(19) Europäisches Patentamt
European Patent Office
Office européen des brevets

(11) Publication number: 0 129 037 B1

(12) EUROPEAN PATENT SPECIFICATION

(45) Date of publication of patent specification: 02.09.87

(51) Int. Cl.[4]: H 01 L 29/78, H 01 L 29/04

(21) Application number: 84105160.0

(22) Date of filing: 08.05.84

# (54) Polysilicon FETs.

(30) Priority: 17.06.83 US 505156

(43) Date of publication of application: 27.12.84 Bulletin 84/52

(45) Publication of the grant of the patent: 02.09.87 Bulletin 87/36

(84) Designated Contracting States: DE FR GB

(56) References cited:
EP-A-0 061 923
EP-A-0 073 603
IEEE ELECTRON DEVICE LETTERS, vol. EDL-4, no. 10, October 1983, NEW YORK (US), S.D.S. MALHI et al.: "p-Channel MOSFET's in LPCVD Polysilicon", pages 369-371.
APPLIED PHYSICS LETTERS, vol. 42, no. 8, April 1983, NEW YORK (US), Y. HIRAI et al.: "Glow discharge polycrystalline silicon thin-film transistors", pages 701-703.

(73) Proprietor: TEXAS INSTRUMENTS INCORPORATED
13500 North Central Expressway
Dallas Texas 75265 (US)

(72) Inventor: Malhi, Satwinder
633 Prestonwood
Richardson, TX 75081 (US)
Inventor: Shah, Rajiv
2116 Newcombe Drive
Plano Texas (US)

(74) Representative: Leiser, Gottfried, Dipl.-Ing. et al
Patentanwälte Prinz, Leiser, Bunke & Partner
Manzingerweg 7
D-8000 München 60 (DE)

(56) References cited:
SOLID STATE ELECTRONICS, vol. 24, no. 11, November 1981, EXETER (GB), H.S. LEE: "The field effect electron mobility of laser-annealed polycrystalline silicon MOSFETs", pages 1059-1066.
IEEE ELECTRON DEVICE LETTERS, vol. EDL-1, no. 8, August 1980, NEW YORK (US), T.I. KAMINS et al.: "Hydrogenation of transistors fabricated in polycrystalline-silicon films", pages 159-161.

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 129 037 B1

## Description

Background and summary of the invention

The present invention relates to a field effect transistor as defined in the precharacterizing part of claim 1.

A field effect transistor of this type is described in EP—A—0 073 603.

For numerous applications it would be desirable to be able to fabricate good quality field effect transistors in polycrystalline semiconductor material. Such a capability would lead to breakthroughs in at least two areas. First, silicon on insulator structures could be fabricated on a very wide variety of substrates. At present, silicon on insulator structures can only be used in those cases where a good lattice match between the silicon active device layer and the insulating substrate can be found. Secondly, and perhaps of even more importance, the capability for good quality polysilicon devices permits vertical integration. That is, at present integrated circuits are essentially two-dimensional devices, and active devices cannot be overlaid one on top of another. However, if it were possible to fabricate active devices having polysilicon channels, such active devices could be formed on an insulator layer on top of another active device. This opens the door to a whole new generation of integrated circuit device design.

However, the numerous prior attempts in the art to build transistors in polysilicon have encountered three major difficulties. First, the mobility (and hence the bulk conductivity) of polysilicon material is inherently very low. Second, leakage problems have normally been found with polysilicon transistors. Third, the threshold voltages of such transistors have been extremely large.

These problems are in some respects complementary. That is, by making the channel of a polysilicon transistor very long, the leakage current can be somewhat reduced. However, in this case, the low mobility of the polysilicon means that the device will have a very large series resistance, so that a huge low-gain device is likely to result if one attempts to design a practical polysilicon transistor using methods of the prior art.

A prior art attempt to design a good polysilicon transistor is described in Applied Physics Letters, vol. 42, No. 8, 15 April 1983, page 701 to 703. The channel region of that device, however, is of intrinsic nature. Various thin-film transistors are known from prior art providing doped or undoped polycrystalline channel regions which are at least 500 nm thick; cf. Solid-State Electronics, vol. 24, No. 11, 1981, pages 1059 to 1066, EP—A—0 061 923 and IEEE Electron Device Letters, vol. EDL-1, No. 8, August 1980, pages 159 to 161. Besides, in the last mentioned document a method of passivating grain-boundary defects by incorporation of hydrogen into the polysilicon channel region has been disclosed.

Thus, it is an object of the present invention to provide a polysilicon-channel transistor having low leakage.

It is a further object of the present invention to provide a polysilicon-channel transistor having low series resistance.

It is a further object of the present invention to provide a polysilicon-channel transistor having low series resistance and relatively small physical size.

It is a further object of the present invention to provide a field effect transistor having a channel region comprised of polycrystalline material, which has low leakage current.

It is a further object of the present invention to provide a field effect transistor having a channel composed of polycrystalline material, which has low on-state series resistance.

It is a further object of the present invention to provide a polysilicon field effect transistor having a low threshold voltage.

The present invention avoids the before-mentioned difficulties, by providing a field effect transistor having the features defined in the characterizing part of claim 1. Such a transistor is operated in the accumulation mode. (I.e. the channel is p-type polysilicon for a PMOS device.) The combination of these characteristics results in a transistor which has low leakage current, high source/drain breakdown voltage, low threshold voltage, and low channel series resistance.

Particular embodiments of the invention are set out in dependent claims 2 to 4.

Brief description of the drawings

The present invention will be described with reference to the accompanying drawings, wherein:

Figure 1 shows a first conceptual embodiment of the present invention;

Figures 2a—2d show the effect of grain boundary passivation on the space charge barriers of the grain boundaries;

Figures 3a—3d show successive stages in the fabrication of another embodiment of the present invention.

Figures 4—6 show further embodiments of the present invention;

Figure 7 shows the effect of hydrogen passivation on the output iv characteristics of a sample device according to the present invention;

Figure 8 shows the effect of hydrogen passivation on the drain current versus gate voltage characteristics of a sample device according to the present invention;

Figures 9a—9f show the effect of hydrogen passivation on the subthreshold characteristics of a sample device according to the present invention;

Figure 10 shows a further sample embodiment of the invention; and

Figure 11 shows a further embodiment of the invention in a vertically integrated structure.

Description of the preferred embodiments

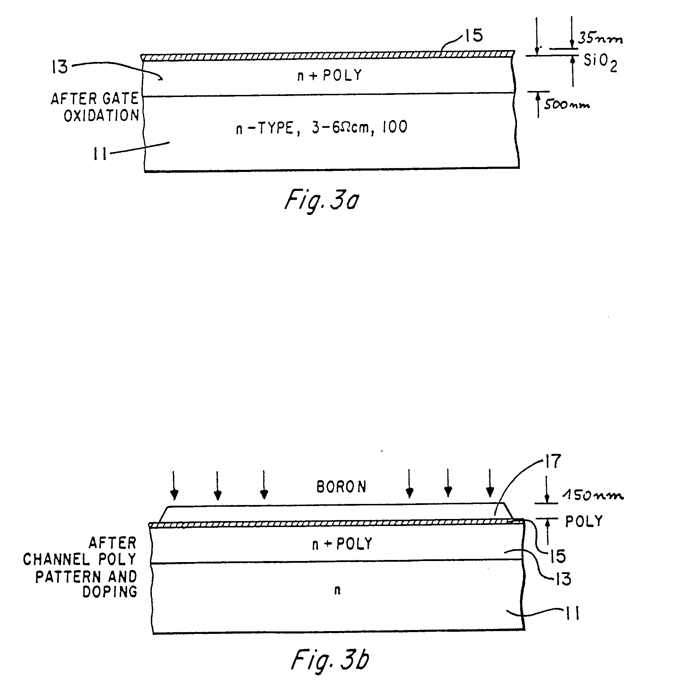

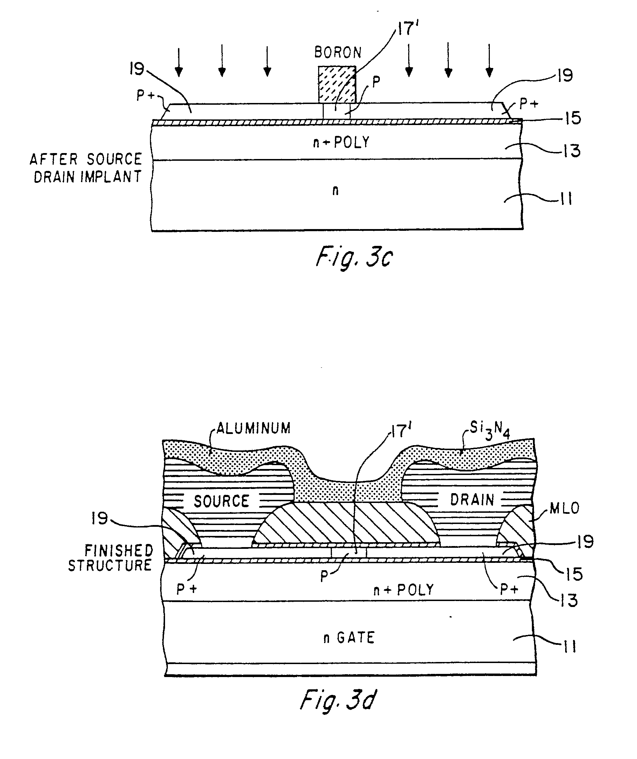

Figure 3 shows the device structure used to build a first embodiment of the invention. The starting material was 3—6 ohm · cm, (100), 3" silicon slices 11. A 500 nm LPCVD polysilicon layer 13 was deposited and doped n+ to 30 ohm/sq. using a $POCl_3$ source. A 35 nm thermal gate oxide 15 was grown. Then a 150 nm layer 17 of undoped LPCVD polysilicon was deposited by pyrolysis of $SiH_4$ at 620°C. Boron implantation was performed at various doses to adjust the doping of channel 17'. Device isolation was accomplished by complete island etch of channel polysilicon layer using a $CHF_3$ based plasma. Source/drain regions 19 were doped by boron implantation.

Two splits of slices were made which either did or did not receive grain boundary passivation by a plasma of hydrogen. The plasma was excited in an equal mixture of $H_2$ and $N_2$ by approximately 800 W of RF power at 13.56 MHz. The samples were held in the plasma at 300°C for a duration of 60 minutes.

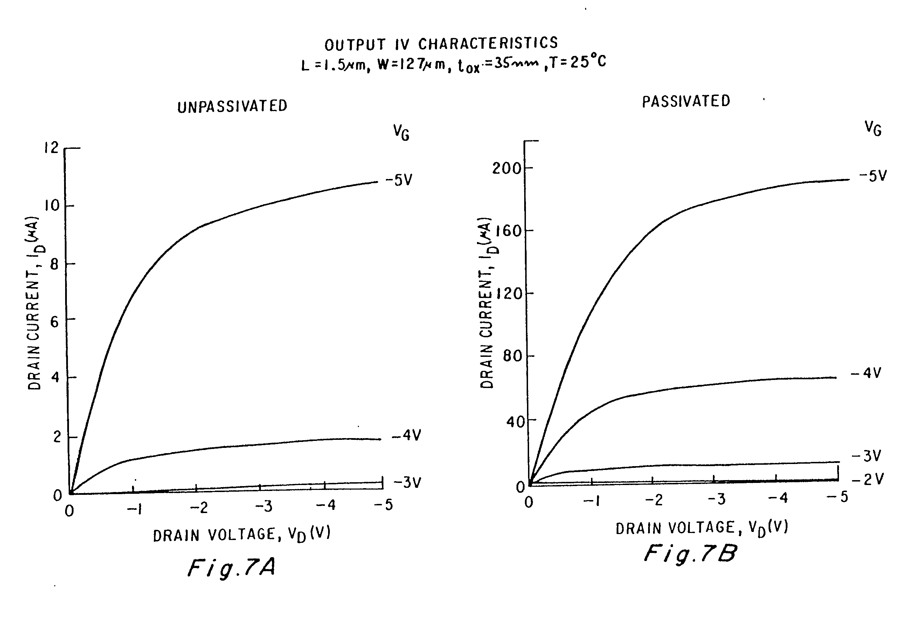

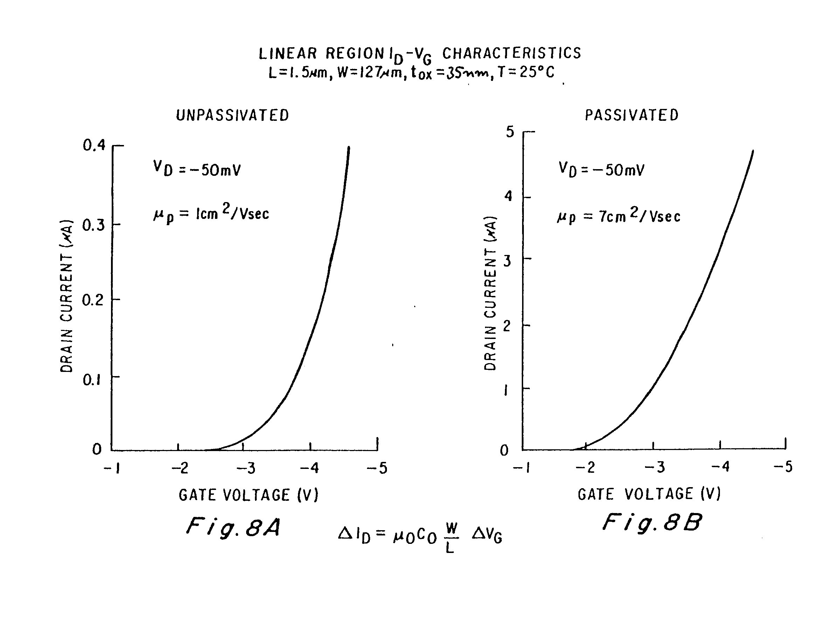

The output characteristics of a first sample device L153/SO4 are shown in Figure 7A. This device has an effective electrical channel width W=127 µm and electrical channel length L=1.5 µm. No hydrogen passivation treatment was carried out on this device. A well behaved MOSFET action is obtained, which is reproducible across the slice and from slice to slice. The drive current, measured at VD=VG=5V, is about 10 µA. The accumulation hole mobility µp in the vicinity of VG=−5V, as determined from the linear region transfer curve shown in Figure 8A, is found to be about 1 $cm^2/V \cdot sec$. Figures 7B and 8B show the output characteristics for a second sample device according to the present invention, L153/S10. The physical parameters of this device are identical to that of L153/S04. The two devices were fabricated with similar processing schedule except that only L153/S10 saw the hydrogen plasma treatment. The drive current for this device is about 200 µA, which is a factor of 20 higher than that of the unpassivated device. The corresponding hole mobility µp is found to be 7 $cm^2/V \cdot sec$.

Polycrystalline silicon is composed of small grains with random orientation separated by ground boundaries. Electrically active traps in the boundary region capture carriers and deplete the surrounding regions, giving rise to a potential barrier. These potential barriers have a significant effect of the conduction behaviour of the MOSFET. The observed increase in driving current after hydrogenation is apparently related to the lowering of intergrain potential barrier, a phenomenon well documented in regard to polycrystalline semiconductor materials. Atomic hydrogen penetrated polysilicon during plasma treatment, saturating the dangling bonds at grain boundaries, thereby reducing the trap density.

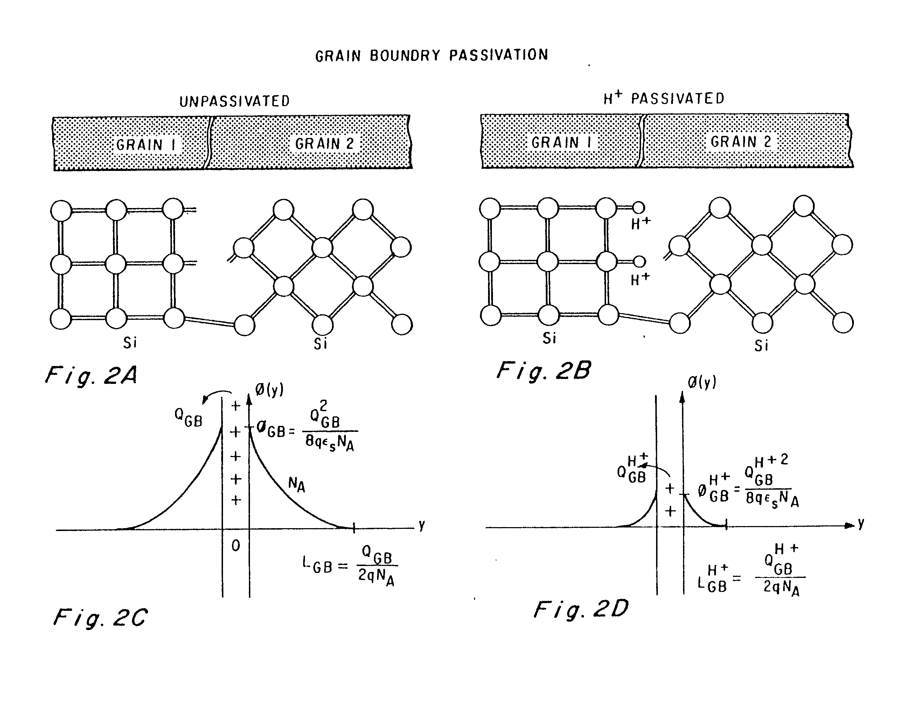

Figure 2 shows the effect of hydrogen passivation on space charges at grain boundaries schematically; Figure 2A shows dangling bonds, Figure 2B shows passivated bonds, Figure 2C shows the potential for Figure 2A, and Figure 2D shows the potential for Figure 2B. Where hydrogen passivation is introduced, as in Figure 2B, the trap density $g_{gb}$ at the grain boundary is dramatically reduced, since many of the dangling bonds are now bonded to hydrogen ions, producing electrically neutral cities. This in turn produced a strong reduction in the potential barrier $phi_{gb}$, which varies as the square of the interface charge density $g_{gb}$: $phi_{gb}=q_{gb}^2/8q\varepsilon_s N_A$.

The subthreshold behaviour of these devices resembles the weak inversion characteristics of bulk silicon MOS transistors. However, the mechanism of origin of subthreshold characteristics in these devices is quite distinct from that of inversion mode bulk MOSFETs. At large gate drives the conduction in these devices is predominantly accumulation mode. With small gate bias, the current is largely supported by acceptor doping in the channel polysilicon layer. It is the gate modulation of this portion of device current that gives rise to the observed turn off property. On lowering the gate voltage, the channel polysilicon layer eventually becomes completely depleted. The current flow is now space charge limited over the potential barrier at the source end resulting in an exponential drain current dependence on gate bias.

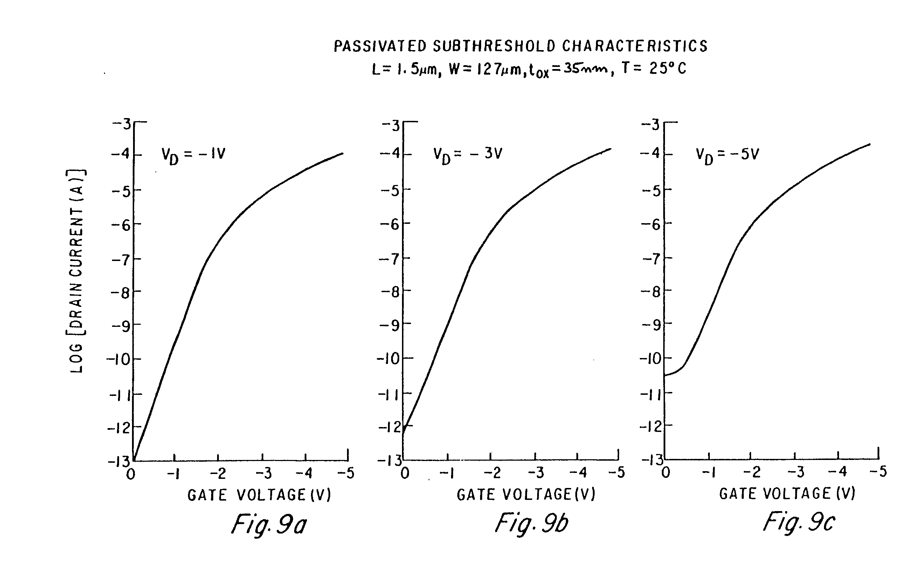

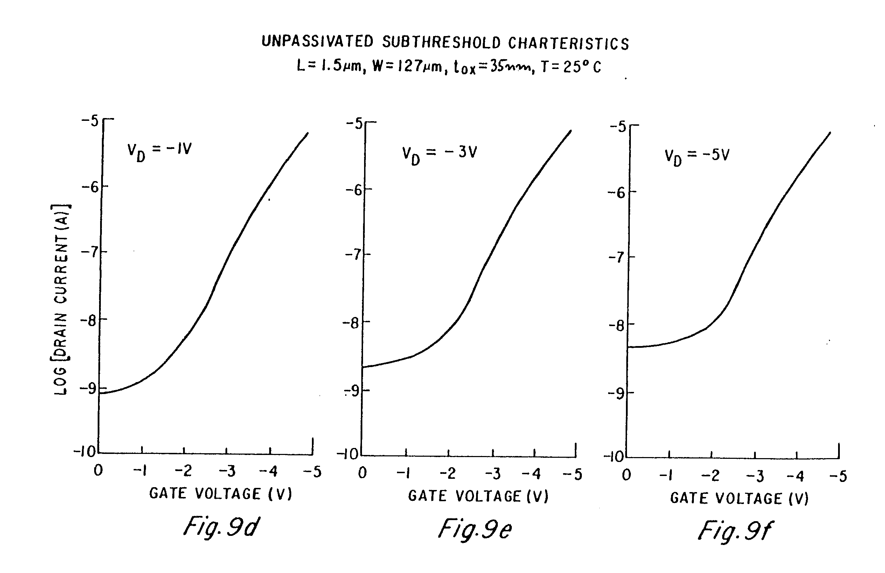

The plasma hydrogen passivation reduces the generation/recombination centers in the channel poly, significantly improving the leakage current. The improvement in subthreshold slope, dramatically apparent in Figures 9A—9F, seems to be related to the reduction in electrically active surface states residing at the gate oxide-channel poly interface. Figures 9A—9C are for passivated devices and Figures 9D—9F are for unpassivated devices.

The spread in electrical parameters across the slices remains largely unaltered before and after passivation. For a majority of the tested devices the drive current is within +15% and the leakage current is within +50% of the mean values. It must be mentioned that contact photolithography was used to pattern the source drain separation and may be mainly responsible for the observed spread in drive current.

The hydrogen annealing is preferably performed by exposing the polysilicon to a hydrogen plasma, e.g. in a standard parallel-plate plasma reactor. For example, an anneal in a plasma discharge at a partial pressure of molecular hydrogen of 1000 µm for 60 minutes for a four inch wafer at a temperature in the neighborhood of 300°C is sufficient. However, this process step is not at all end point sensitive. The hydrogen is introduced very rapidly, and simply serves to saturate the danling bonds at the grain boundaries. An excess of hydrogen is innocuous.

Thus, the transistors of the present invention are preferably made using hydrogen-annealed polysilicon, although the hydrogen annealing step is not strictly necessary.

However, it should be noted that the hydrogen anneal preferably used is an atomic hydrogen anneal and not a molecular hydrogen anneal. That is, the plasma dissociates the $H_2$ feed gas into species such as H+ ions and monatomic hydrogen free radicals, which are more easily linked with the dangling bonds at the grain boundary sites.

The hydrogen will also pass easily through a reasonably thin oxide cap (e.g. 700 nm). However, a thick nitride cap will retard the in-diffusion of the hydrogen significantly.

It should also be noted that prolonged high temperature processing steps subsequent to the hydrogen anneal should be avoided. If prolonged high temperature steps are subsequently used, the danger is that the atomic hydrogen which is passivated in the grain boundaries will recombine and outdiffuse as molecular hydrogen. This means that the benefits of passivation at grain boundaries will gradually be lost, and the space charge barriers will gradually increase, degrading mobility and leakage. However, this is a gradual degradation rather than a catastrophic one, and a moderate amount of high-temperature steps can be tolerated. For example, an hour at 450°C, under the hydrogen and the only conditions noted above, can be tolerated easily. Longer high-temperature steps can also be tolerated, although it is preferable to minimize the subsequent high-temperature time where this can conveniently be done. For example, it is preferred to use a low-temperature multilevel oxide planarization step, rather than the conventional high-temperature PSF reflow. The presently preferred embodiment of this is to use OCD spin-on silicate solutions, which are then baked at low temperature to evaporate the organic solvent. However, a variety of other low-temperature MLO planarization methods can be used, including MLO reflow by transient heating (e.g. by laser annealing), or use of other low-temperature MLO materials, such as BPSG, lead-doped silica glasses, or organics such as polyimid or PIQ.

It should also be noted that, in the presently preferred embodiment, the contact sintering times and temperatures are slightly reduced. That is, LOM doped with 1% silicon is preferably sintered in hydrogen for ten minutes at 400°.

It should be noted that the effects of hydrogen escape during subsequent high-temperature processing steps can be somewhat mitigated by performing the initial hydrogen passivation anneal for longer time and/or a higher partial pressure of hydrogen.

It should also be noted that hydrogen is not the only passivating species which can be used, although it is presently preferred. Fluorine can also be used, and it is believed that other halogen elements are also useful.

Alternatively, hydrogen ions could be implanted for grain boundary passivation, but this is certainly not a preferred embodiment.

It should also be noted that the present invention is not only applicable to insulated gate field effect transistors, but could also be applied to junction field effect transistors having a polysilicon gate. However, the insulated gate embodiment of the present invention is definitely preferred. In particular, the fast and uneven diffusion of dopants characteristic of polysilicon means that diffusion across the silicon/polysilicon boundary is likely to induce undesirable spreading device characteristics.

Thus, the present invention teaches a polysilicon transistor which is different from the polysilicon transistors heretofore known in three important was

1. the channel region is thin;
2. the channel region is highly doped;
3. the channel region has the same doping type as the polysilicon source and drain regions, i.e. the transistor is operated in accumulation mode;
4. the transistor is preferably passivated in hydrogen.

The use of high doping levels in the channel greater than $5\times10^{16}$ per cubic centimeter produces two clearly desirable results: the threshold voltage is decreased. As extensively discussed above, high threshold voltages have been a crucial stumbling block to use of prior art polysilicon channel transistors. Secondly, the drain current is substantially increased. Third, the depletion depth $x_d$, i.e. the depletion depth corresponding to the built in Fermi potential, is decreased.

A crucial teaching of the present invention is that the polysilicon channel layer must be thin enough that it is depleted through, that is t is equal to or less than $x_d+x_b$, where $x_b$ is the backside depletion depth caused by the fixed charge typically found at the polysilicon/silicon dioxide backside interface. (This fixed charge will typically produce a depletion depth of about 100 nm at a polydoping level of $10^{17}$ per cubic centimeter.)

The use of a thin channel means that a heavily doped accumulation mode channel can be used while achieving good turn off characteristics. Thus, the present invention is the first to achieve the combination of good threshold voltage, good on-state serious resistance, and good turn-off characteristics (low leakage).

A further advantage of the use of a thin polysilicon layer for channel regions is topographic. That is, a 150 nm layer of polysilicon, as used for transistors according to the present invention, will produce fewer step coverage problems in subsequent layers than will the thicker polysilicon layers typically used in the prior art.

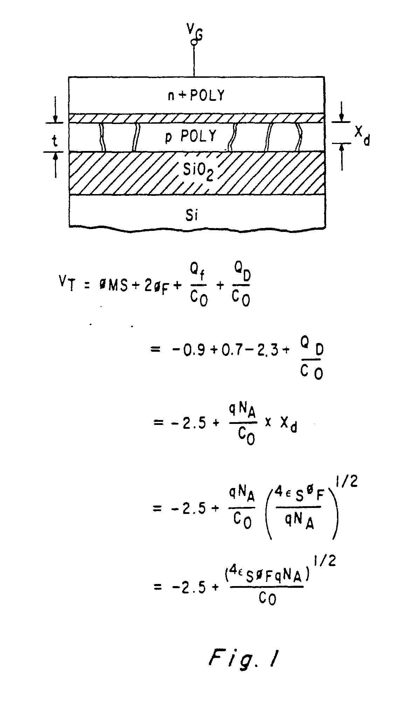

As illustrated in Figure 1:

$$V_T=\phi_{MS}+2\phi_F+\frac{Q_f}{C_o}+\frac{Q_D}{C_o}$$

$$=-0.9+0.7-2.3+\frac{Q_D}{C_o}$$

$$= -2.5 + \frac{qN_A}{C_o} \times X_d$$

$$= -2.5 + \frac{qN_A}{C_o}\left(\frac{4\varepsilon_S\Phi_F}{qN_A}\right)^{\frac{1}{2}}$$

$$= -2.5 + \frac{(4\varepsilon_S\Phi_F qN_A)^{\frac{1}{2}}}{C_o}$$

Increasing $N_A$ produces:
1. decreasing $V_T$
2. increasing $I_D$
3. decreasing $X_d$

To prevent leakage:
1. $t \leq X_d$

use thin channel poly

$$100\ \text{nm} < t \leq 150\ \text{nm}$$

Thin channel poly produces:
1. large drive current
2. low leakage current
3. small vertical step

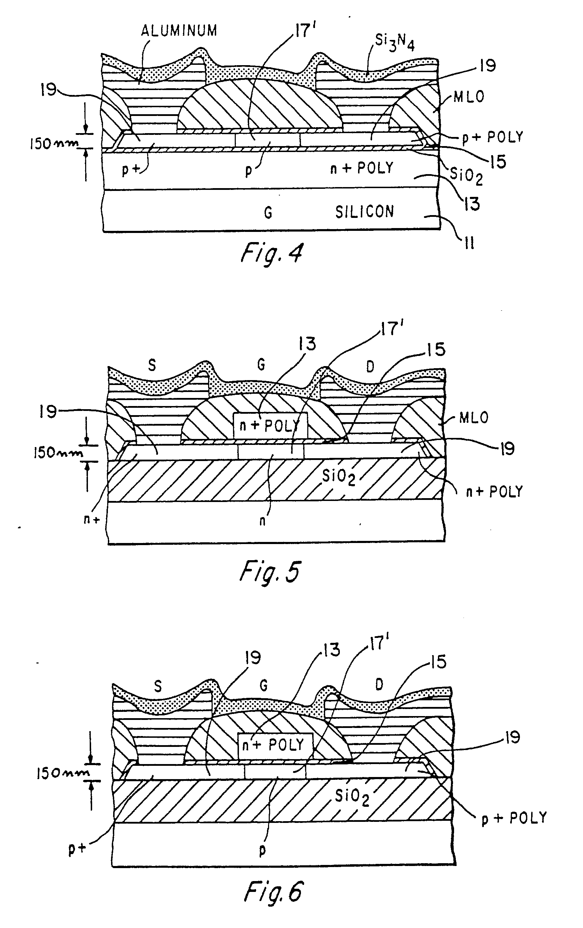

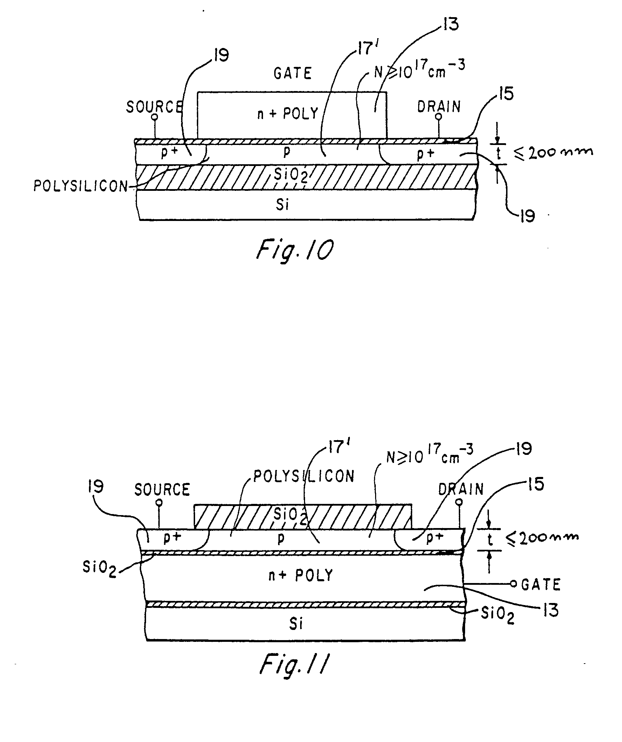

Figures 4, 5, 6, 10, and 11 show a few of the many device embodiments in which the present invention can be configured and numbered analogous to Figure 3 without regard for exchange of n-type and p-type regions, etc. As is obvious to those skilled in the art, the present invention provides a fundamentally new device structure, which can be embodied in a tremendous variety of integrated circuits, and which solves a high variety of circuit designer's problems.

In addition, the key teaching of thin channel regions with high doping can be embodied in a wide variety of specific thicknesses and channel doping levels. For example, channel thicknesses of less than 350 nm, at channel doping levels of greater than $5 \times 10^{16}$ per cubic centimeter, are within the scope of a first embodiment of the present invention. Additionally, polysilicon transistors having channel thicknesses of 200 nm or less at channel doping of at least $10^{17}$, are also within the scope of the present invention. In general, the accumulation mode polysilicon device having a mobility of at least five centimeters square per volt second, and a channel thickness of 200 nm or less, is also within the scope of the present invention.

A further advantage of the use of thin polysilicon transistors according to the present invention, in some applications, is that the spontaneous growth in grain size is limited. That is, for VLSI applications MOSFETS having channel lengths on the order of one or two µm are required. The grain size of as-deposited polysilicon will typically be in the range of 30 to 50 nm, so that the number of grain boundaries cutting across the electrically shortest channel length will be reasonably large, e.g. 20 or more, and the variation in the numbers of grain boundaries cutting the channel regions of a particular device will cause only a moderate spread in device characteristics. However, if the grain size of the polysilicon spontaneously increases during processing, which it is likely to do, the average number of grain boundaries which lie across the electrically minimal channel is likely to decrease, which means that a much larger spread in device characteristics is likely to result. That is, if the polysilicon grain size spontaneously increases to near one µm, due to high-temperature steps during device processing, as is likely to happen, some devices will have no grain boundaries cutting the channel, some will have one, and some may have two or more. To the extent that the space charge barriers at grain boundaries can be reduced, this source of device characteristics spread becomes less important, as discussed above regarding the hydrogen passivation step. However, since present art does not entirely eliminate the effects of the grain boundaries, it is desirable to minimize the spread in device characteristics which results from the electrical effects of the grain boundaries. In this respect, the use of a thin polysilicon layer is helpful, since polysilicon thicknesses of 200 nm or less retard the increase in grain size which would otherwise occur spontaneously during processing.

Thus, the present invention advantageously provides a polysilicon transistor having low leakage and low series resistance.

Of course, transistors fabricated according to the present invention can be used in a wide variety of integrated circuit devices. For example, in addition to the silicon on insulator embodiments primarily discussed above, vertically integrated embodiments such as shown in Figure 11 can also be used.

Moreover, silicon dioxide is not the only insulating substrate which can be used underneath a polysilicon transistor according to the present invention. A tremendous variety of other substrates can be used, such as sapphire, spinel silicate glasses, ceramics, etc.

Moreover, it should also be noted that the present invention is not specifically limited to a polycrystalline silicon transistor, although that is believed to be its primary application, but is also applicable to transistors formed in other polycrystalline semiconductor materials. The key teachings of the present invention in this respect are that the channel layers should be relatively thin and the channel doping levels should be relatively high and of the same type as the device on-state channel conductivity type. In embodiments using polysilicon, the channel thickness is preferably less than 300 nm, and the channel doping preferably greater than $10^{17}$ per $cm^3$. In applying the present invention to other semiconductors, the channel thickness can be adjusted in proportion to the square root of the permittivity of the semiconductgr used. Similarly, the dopant concentration is preferably chosen merely to achieve a carrier concentration of greater than $5 \cdot 10^{16}$ in the particular semiconductor used.

As will be obvious to those skilled in the art, the present invention teaches a fundamental new device structure which can be used in a wide variety of integrated circuit device designs. Thus, not only can the foregoing description be modified and varied in a very wide number of respects, but an extremely broad range of equivalents is expressly asserted for the present invention, which is not limited except as specified in the following claims.

**Claims**

1. A field effect transistor comprising a channel region (17') made from polycrystalline semiconductor material (17), source and drain regions (19) connected to said channel region (17'), and a gate (11, 13) positioned to apply an electric field to said channel region (17') between said source and drain regions (19), characterized in that said channel region (17') is sufficiently thin to be depleted at zero applied gate voltage and has a carrier concentration of greater than five times $10^{16}$ $cm^{-3}$ and further is of the same conductivity type as the source and drain regions (19).

2. The transistor of claim 1 wherein said polycrystalline material (17) comprises polysilicon.

3. The transistor of claim 2 wherein said polysilicon (17) contains a substantial admixture of a passivating species at grain boundaries thereof.

4. The transistor of claim 2 wherein said gate (13) also comprises polysilicon, said gate (13) and channel regions (17') being doped with the same conductivity type.

**Patentansprüche**

1. Feldeffekttransistor mit einer Kanalzone (17') aus polykristallinem Halbleitermaterial (17), mit der Kanalzone (17') verbundenen Source- und Drain-Zonen (19) und einem Gate (11, 13), das so angeordnet ist, daß an die Kanalzone (17') zwischen den Source- und Drain-Zonen (19) ein elektrisches Feld angelegt wird, dadurch gekennzeichnet, daß die Kanalzone (17') genügend dünn ist, daß sie dann, wenn keine Gate-Spannung anliegt, verarmt ist, und daß die Kanalzone eine Ladungsträgerkonzentration größer als $5 \times 10^{16}$ $cm^{-3}$ hat und den gleichen Leitungstyp wie die Source- und Drain-Zonen (19) aufweist.

2. Transistor nach Anspruch 1, dadurch gekennzeichnet, daß das polykristalline Material (17) Polysilicium ist.

3. Transistor nach Anspruch 2, dadurch gekennzeichnet, daß das Polysilicium (17) eine wesentlichen Beimischung eines Passivierungsmittels an seinen Korngrenzen enthält.

4. Transistor nach Anspruch 2, dadurch gekennzeichnet, daß das Gate (13) ebenfalls aus Polysilicium besteht, wobei das Gate (13) und die Kanalzonen (17') mit dem gleichen Leitungstyp dotiert sind.

**Revendications**

1. Transistor à effet de champ comportant une zone de canal (17') en un matériau polycristallin semiconducteur (17), des zones de source et de drain (19) reliées à ladite zone de canal (17') et une grille (11, 13) positionnée de manière à appliquer un champ électrique à ladite zone de canal (17') entre lesdites zones de source et de drain (19), caractérisé en ce que ladite zone de canal (17') est suffisamment mince pour être appauvrie à une tension nulle appliquée à la grille, et possède une concentration de porteurs supérieure à $5 \times 10^{16}$ $cm^{-3}$, et est en outre du même type de conductivité que les zones de source et de drain (19).

2. Le transistor selon la revendication 1, dans lequel le matériau polycristallin (17) comprend du polysilicium.

3. Le transistor selon la revendication 2, dans lequel ledit polysilicium (17) contient une addition substantielle d'une espèce de passivation à ces interfaces de grains.

4. Le transistor selon la revendication 2, dans lequel ladite grille (13) comprend également du polysilicium, lesdites zones de grille (13) et de canal (17') étant dotées du même type de conductivité.

$V_G$
n + POLY
p POLY
$SiO_2$
Si
t
$X_d$

$$V_T = \phi_{MS} + 2\phi_F + \frac{Q_f}{C_0} + \frac{Q_D}{C_0}$$

$$= -0.9 + 0.7 - 2.3 + \frac{Q_D}{C_0}$$

$$= -2.5 + \frac{qN_A}{C_0} \times X_d$$

$$= -2.5 + \frac{qN_A}{C_0}\left(\frac{4\epsilon_S \phi_F}{qN_A}\right)^{1/2}$$

$$= -2.5 + \frac{(4\epsilon_S \phi_F q N_A)^{1/2}}{C_0}$$

*Fig. 1*

GRAIN BOUNDRY PASSIVATION
UNPASSIVATED
H+ PASSIVATED
GRAIN I
GRAIN 2
Si
H+
Ø(y)
y
Fig. 2A
Fig. 2B
Fig. 2C
Fig. 2D

15
35nm
SiO2
13
n + POLY
500nm
AFTER GATE
OXIDATION
n-TYPE, 3-6Ωcm, 100
11

*Fig. 3a*

17
BORON
150nm
POLY
AFTER
CHANNEL POLY
PATTERN AND
DOPING
n + POLY
15
13
n
11

*Fig. 3b*

17'
BORON
19
P
19
P+
P+
15
n+POLY
13
AFTER SOURCE
DRAIN IMPLANT
n
11

*Fig. 3c*

ALUMINUM
17'
$Si_3N_4$
SOURCE
DRAIN
MLO
19
19
FINISHED
STRUCTURE
15
P
P+
n+POLY
P+
13
n GATE
11

*Fig. 3d*

ALUMINUM
17'
$Si_3N_4$
19
19
MLO
150 nm
p + POLY
15
p +
p
n + POLY
$SiO_2$
13
G
SILICON
11

*Fig. 4*

17'
13
15
S
G
D
19
n + POLY
MLO
150 nm
19
$SiO_2$
n + POLY
n +
n

*Fig. 5*

19
13
17'
15
S
G
D
n + POLY
19
150 nm
$SiO_2$
p + POLY
p +
p

*Fig. 6*

OUTPUT IV CHARACTERISTICS
L = 1.5μm, W=127μm, $t_{ox}$=35nm, T=25°C
UNPASSIVATED
PASSIVATED
$V_G$
-5V
-4V
-3V
-2V
DRAIN CURRENT, $I_D$(μA)
12
10
8
6
4
2
0
200
160
120
80
40
DRAIN VOLTAGE, $V_D$(V)
-1
-2
-3
-4
-5


Fig.7A

Fig.7B

LINEAR REGION I_D-V_G CHARACTERISTICS
L=1.5μm, W=127μm, t_ox=35nm, T=25°C
UNPASSIVATED
V_D = −50mV
μp = 1cm²/Vsec
DRAIN CURRENT (μA)
0.4
0.3
0.2
0.1
0
−1
−2
−3
−4
−5
GATE VOLTAGE (V)
PASSIVATED
V_D = −50mV
μp = 7cm²/Vsec
DRAIN CURRENT (μA)
5
4
3
2
1
0
−1
−2
−3
−4
−5
GATE VOLTAGE (V)
ΔI_D = μ0C0 W/L ΔV_G

Fig. 8A

Fig. 8B

PASSIVATED SUBTHRESHOLD CHARACTERISTICS

$L = 1.5\mu m$, $W = 127\mu m$, $t_{ox} = 35nm$, $T = 25°C$


$V_D = -1V$
LOG [DRAIN CURRENT (A)]
GATE VOLTAGE (V)


Fig. 9a


$V_D = -3V$
GATE VOLTAGE (V)


Fig. 9b


$V_D = -5V$
GATE VOLTAGE (V)


Fig. 9c

UNPASSIVATED SUBTHRESHOLD CHARTERISTICS

L = 1.5μm, W = 127μm, $t_{ox}$ = 35nm, T = 25° C


LOG [DRAIN CURRENT (A)]
-5
-6
-7
-8
-9
-10
$V_D$ = -1V
0 -1 -2 -3 -4 -5
GATE VOLTAGE (V)


Fig. 9d


-5
-6
-7
-8
-9
-10
$V_D$ = - 3V
0 -1 -2 -3 -4 -5
GATE VOLTAGE (V)


Fig. 9e


-5
-6
-7
-8
-9
-10
$V_D$ = -5V
0 -1 -2 -3 -4 -5
GATE VOLTAGE (V)


Fig. 9f

13
17'
19
GATE
N≥10^17 cm^-3
15
SOURCE
n + POLY
DRAIN
p+
p
p+
t
≤200 nm
SiO2
POLYSILICON
Si
19

*Fig. 10*

17'
N≥10^17 cm^-3
19
POLYSILICON
15
19
SOURCE
DRAIN
SiO2
p+
p
p+
t
≤200 nm
SiO2
n+ POLY
GATE
13
SiO2
Si

*Fig. 11*